# EUROPEAN PATENT APPLICATION

(11) **EP 1 633 002 A2**
(43) Date of publication of application: **08.03.2006**
(21) Application number: 05255322.9
(22) Date of filing: 31.08.2005
(51) Int. Cl.: H01L 27/146

(54) **Semiconductor device, semiconductor module, and manufacturing method of semiconductor device**

(30) Priority: 31.08.2004 JP 2004251235
(71) Applicant: SHARP KABUSHIKI KAISHA, Osaka-shi, Osaka 545-8522 (JP)
(72) Inventor: Tsukamoto, Hiroaki, Yamatotakada-shi, Nara 635-0045 (JP); Fujita, Kazuya, Nabari-shi, Mie 518-0475 (JP); Yasudome, Takashi, c/o Room 203 Royal Palace, Fukuyama-shi, Hiroshima 721-0907 (JP)
(74) Representative: Brown, Kenneth Richard

(57) **Abstract**

An imaging device as a semiconductor device includes a semiconductor substrate on which an imaging element is mounted, a light-transmitting lid section (covering section) arranged to face a light receiving section provided on one surface of the imaging element, and an adhesive layer arranged in an area excluding the light receiving section on the one surface of the imaging element for bonding between the semiconductor substrate and the lid section. The adhesive layer ranges from 10 g/(m²·24h) to 200 g/(m²·24h) in the water vapor permeability.

## Description

### BACKGROUND OF THE INVENTION

### 1. Field of the Invention

The present invention relates to a semiconductor device having a semiconductor substrate provided with a covering section, a semiconductor module employing the semiconductor device, and a manufacturing method of the semiconductor device. More particularly, the present invention relates to a semiconductor device in which a space provided between its semiconductor substrate and covering section is protected at the interior from condensation, a semiconductor module, and a manufacturing method of the semiconductor device.

### 2. Description of Related Art

Imaging devices such as an area sensor or a linear sensor including an imaging element such as a CCD or a CMOS imager, have been put to practical use in various fields as one type of the semiconductor device. An imaging device consists mainly of a light receiving section such as a photodiode and a circuit such as a readout section for reading electrical signals based on output of the light receiving section.

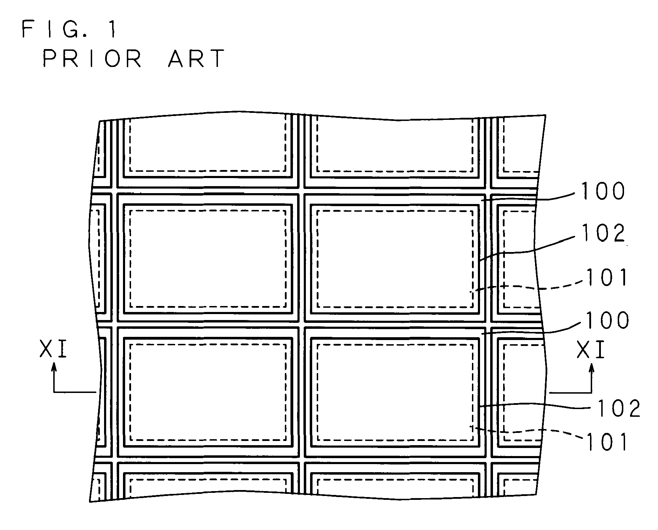

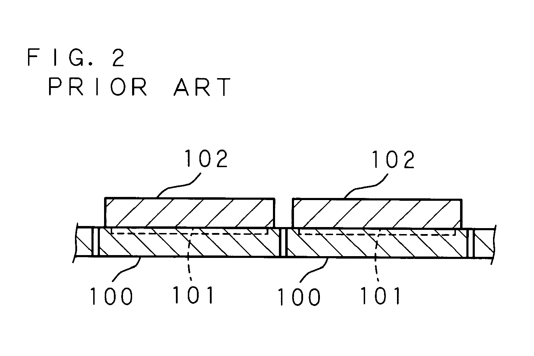

FIG. 1 is a plan view showing schematically an arrangement of such a conventional imaging device. FIG. 2 is a structure cross sectional view taken along a line XI-XI of FIG. 1. The conventional imaging device is produced by covering image sensor sections 101 of chips 100 arrayed on a semiconductor substrate in a wafer state, bonding cap glasses 102 not so as to overlap their bonding area with the image sensor sections 101, and then separating the semiconductor substrate into the chips 100, 100, ... (see, for example, Japanese Patent Application Laid Open No. 03-151666 (1991)). As the image sensor section 101 is protected with the cap glass 102, generation of damage and adhesion of dirt on the image sensor section 101 can be avoided at any production step after the bonding of the cap glass 102.

However, in the technology disclosed in Japanese Patent Application Laid Open No. 03-151666 (1991), there is a problem that the adhesive used for bonding the cap glass 102 to the chip 100 permits moisture to enter the interior of the device from a bonding part under a high temperature, high moisture atmosphere, as the entered moisture is hardly discharged from the device to the outside readily, it may produce condensation in the sealed space.

### BRIEF SUMMARY OF THE INVENTION

The present invention has been made with the aim of solving the above problem, and it is an object of the present invention to provide a semiconductor device and a semiconductor module where a semiconductor substrate and a covering section for covering the semiconductor substrate are bonded to each other by an adhesive layer of which the water vapor permeability ranges from 10 g/(m²·24h) to 200 g/(m²·24h). Accordingly, even if moisture enter the interior of the space defined by the semiconductor substrate, the covering section, and the adhesive layer, the moisture can readily be discharged to the outside thus permitting no condensation in the interior of the space. As a result, the semiconductor device and semiconductor module are improved in the resistance to moisture.

It is another object of the present invention to provide a semiconductor device and a semiconductor module where an imaging element having a light receiving section is provided on a semiconductor substrate and a covering section is arranged to face the light receiving section, thus permitting no condensation on the surface of the light receiving section.

It is still another object of the present invention to provide a semiconductor device and a semiconductor module where an adhesive layer is arranged in an area excluding a light receiving section, thus preventing the light receiving section from being physically stressed by the adhesive layer and avoiding any declination in the light transmitting property between the light receiving section and the covering section.

It is yet another object of the present invention to provide a semiconductor device and a semiconductor module where two substrates are bonded to each other by an adhesive layer of which the water vapor permeability ranges from 10 g/(m²·24h) to 200 g/(m²·24h), thus allowing moisture to be readily discharged from the space between the two substrates and the adhesive layer even when the moisture having entered the space under a high temperature, high moisture atmosphere but not to lead to condensation.

It is yet another object of the present invention to provide a semiconductor device and a semiconductor module where the water absorbing rate of an adhesive layer is not higher than 20%, thus securely improving the resistance to moisture in the adhesive layer.

It is yet another object of the present invention to provide a semiconductor device and a semiconductor module where the water absorbing rate of an adhesive layer is not lower than 3%, thus preventing condensation using an adhesive layer with good water permeability.

It is yet another object of the present invention to provide a semiconductor device and a semiconductor module where the adhesive layer contains a water permeable material of which the particles are not greater than 10 µm in the diameter, thus securely improving the resistance to moisture in the adhesive layer.

It is yet another object of the present invention to provide a semiconductor device and a semiconductor module where the adhesive layer contains a water permeable material of which the particles are not smaller than 0.01 µm in the diameter, thus preventing condensation using an adhesive layer with good water permeability.

It is yet another object of the present invention to provide a semiconductor device and a semiconductor module where the adhesive layer includes photo-curing resin, thermosetting resin, and a water permeable material and can thus be shaped and positioned at higher accuracy by a photolithographic technology, thus increasing the bonding strength between a semiconductor substrate and a covering section by heating the adhesive layer up.

It is yet another object of the present invention to provide a manufacturing method of a semiconductor device, which comprises the steps of bonding covering section by an adhesive layer to a semiconductor substrate on which a plurality of semiconductor elements are mounted, and separating the semiconductor substrate when the adhesive layers range from 10 g/(m²·24h) to 200 g/(m²·24h) in the water vapor permeability so as to complete each of the semiconductor elements provided with its covering section, whereby the space defined by the semiconductor substrate, the covering section, and the adhesive layer can be protected from being fouled with cutting water when the cutting water is used during the separating step or even if moisture enters the space, it can readily be discharged from the space to the outside and prevented from leading to condensation.

It is yet another object of the present invention to provide a manufacturing method of a semiconductor device, which comprises the steps of forming a desired pattern of the adhesive layer including photo-curing resin, thermosetting resin, and a water permeable material by a known photolithographic technology utilizing the characteristics of the photo-curing resin included in the adhesive layer at exposure and development processes, positioning a semiconductor substrate and a covering section to face each other, and heating the adhesive layer of the desired pattern for bonding between the semiconductor substrate and the covering section due to the effect of the characteristics of the thermosetting resin included in the adhesive layer, whereby the desired pattern of the adhesive layer can be provided on the semiconductor substrate or the covering section accurately and finely by the photolithographic technology.

It is yet another object of the present invention to provide a manufacturing method of a semiconductor device, which comprises the steps of printing (transferring) an adhesive layer including thermosetting resin and a water permeable material on a semiconductor substrate or a covering section with the use of a printing plate having a pattern corresponding to a predetermined area, positioning the semiconductor substrate and the covering section to face each other, heating up the adhesive layer printed down to cure the thermosetting resin included in the adhesive layer for bonding between the semiconductor substrate and the covering section due to the effect of the characteristics of the thermosetting resin included in the adhesive layer, whereby the desired pattern of the adhesive layer can be printed down on the semiconductor substrate or the covering section using the printing plate at a lower cost thus contributing to the improvement of the productivity.

It is yet another object of the present invention to provide a manufacturing method of a semiconductor device, which comprises the steps of dispensing an adhesive layer including thermosetting resin and a water permeable material on a semiconductor substrate or a covering section so as to be a pattern corresponding to a predetermined area, positioning the semiconductor substrate and the covering section to face each other, heat up the adhesive layer dispensed for bonding between the semiconductor substrate and the covering section due to the effect of the characteristics of the thermosetting resin included in the adhesive layer, whereby the adhesive layer can be provided on the semiconductor substrate or the covering section using a dispenser at a lower cost and in case that the adhesive layer is partially injured and lost, its loss can be repaired by the action of the dispenser.

It is yet another object of the present invention to provide a manufacturing method of a semiconductor device, which comprises the steps of forming an adhesive layer including photo-curing resin, thermosetting resin, and a water permeable material on a semiconductor substrate on which a plurality of imaging elements with light receiving sections are mounted or on each of light-transmitting covering sections corresponding to the light receiving sections of the imaging elements, exposing the adhesive layer selectively to cure the photo-curing resin in an area of the adhesive layer excluding the area of each of the light receiving sections due to the effect of the characteristics of the photo-curing resin included in the adhesive layer, removing the area of the adhesive layer where the photo-curing resin remains not cured over the light receiving section to form a pattern of the adhesive layer, positioning the semiconductor substrate and each of the covering sections to face each other through the adhesive layer of the pattern and curing the thermosetting resin included in the adhesive layer by heating thus to bond between the semiconductor substrate and each of the covering sections, and separating the semiconductor substrate when the adhesive layer ranges from 10 g/(m²·24h) to 200 g/(m²·24h) in the water vapor permeability so as to complete a semiconductor device having each of the imaging elements provided with its covering section, whereby the cutting water used during the separating step cannot be allowed to enter the space defined by the semiconductor substrate, the covering section, and the adhesive layer or even if the cutting water enter the space, it can readily be discharged to the outside for allowing no condensation.

It is yet another object of the present invention to provide a manufacturing method of a semiconductor device, which comprises the steps of forming an adhesive layer including photo-curing resin, thermosetting resin, and a water permeable material on a semiconductor substrate on which a plurality of imaging elements with light receiving sections are mounted or on a light-transmitting covering section for covering the light receiving sections of the imaging elements, exposing the adhesive layer selectively to cure the photo-curing resin in an area of the adhesive layer excluding the area of each of the light receiving sections due to the effect of the characteristics of the photo-curing resin included in the adhesive layer, removing the area of the adhesive layer where the photo-curing resin remains not cured over each of the light receiving sections to form a pattern of the adhesive layer, positioning the semiconductor substrate and the covering section to face each other through the adhesive layer of the pattern and curing the thermosetting resin included in the adhesive layer by heating thus to bond between the semiconductor substrate and the covering section, and separating the semiconductor substrate with the covering section mounted thereon when the adhesive layer ranges from 10 g/(m²·24h) to 200 g/(m²·24h) in the water vapor permeability so as to complete a semiconductor device having each of the imaging elements provided with its covering section, whereby the cutting water used during the separating step cannot be allowed to enter the space defined by the semiconductor substrate, the covering section, and the adhesive layer or even if the cutting water enter the space, it can readily be discharged to the outside for allowing no condensation, and in addition whereby the adhesive layer when provided on the semiconductor substrate can be provided in relation with each of the imaging elements thus eliminating the positioning at high accuracy between the adhesive layer and each of the light-transmitting covering sections in one extra step.

A semiconductor device according to the present invention is a semiconductor device comprising a semiconductor substrate; a covering section for covering the semiconductor substrate; and an adhesive layer for bonding between the semiconductor substrate and the covering section, wherein the water vapor permeability of the adhesive layer ranges from 10 g/(m²·24h) to 200 g/(m²·24h).

Since the water vapor permeability of the adhesive layer ranges from 10 g/(m²·24h) to 200 g/(m²·24h), moisture when entering the space defined by the semiconductor substrate, the covering section, and the adhesive layer under a high temperature, high moisture atmosphere can readily be discharged to the outside. Accordingly, the space defined by the semiconductor substrate, the covering section, and the adhesive layer will be improved in the resistance to moisture, permitting no condensation. Also, the space defined by the semiconductor substrate, the covering section, and the adhesive layer will be protected from any dust entering from the outside, thus increasing the reliability and the environmental protection.

The semiconductor device according to the present invention is characterized in that the semiconductor substrate has an imaging element with a light receiving section provided thereon, and the covering section is positioned to face the light receiving section.

Since the semiconductor substrate has an imaging element with a light receiving section provided thereon and the covering section is positioned to face the light receiving section, the light receiving section remains in the space defined by the semiconductor substrate, the covering section, and the adhesive layer and can thus be protected at the surface from condensation.

The semiconductor device according to the present invention is characterized in that the adhesive layer is arranged in an area excluding the area of the light receiving section.

Since the adhesive layer is arranged in an area excluding the area of the light receiving section, the light receiving section can be protected from being physically stressed by the adhesive layer. Also, the light transmitting property between the light receiving section and the covering section will be avoided from any declination.

A semiconductor device according to the present invention is a semiconductor device comprising: two substrates; an adhesive layer for bonding between the two substrates; and a semiconductor element mounted on one surface of at least one of the two substrates so as to face the other substrate, wherein the adhesive layer is arranged on the one surface excluding the area where the semiconductor element is mounted and a water vapor permeability of the adhesive layer ranges from 10 g/(m²·24h) to 200 g/(m²·24h).

Since the water vapor permeability in the adhesive layer ranges from 10 g/(m²·24h) to 200 g/(m²·24h), moisture when entering the space defined by the two substrates and the adhesive layer under a high temperature, high moisture atmosphere can readily be discharged to the outside. Accordingly, the space defined by the two substrates and the adhesive layer will be protected from condensation. Also, since the semiconductor element is provided on one surface of at least one of the two substrates with the adhesive layer positioned in an area excluding the area of the semiconductor element, it can be protected from being fouled with moisture (humidity).

The semiconductor device according to the present invention is characterized in that the adhesive layer has a water absorbing rate of not higher than 20%.

The semiconductor device according to the present invention is characterized in that the adhesive layer has a water absorbing rate of not smaller than 3%.

Since the adhesive layer has a water absorbing rate of not higher than 20%, its resistance to moisture can certainly be improved. The adhesive layer, when having a water absorbing rate of smaller than 3%, will be declined in the water vapor permeability. Accordingly, when the adhesive layer is not smaller than 3% or preferably not smaller than 5% in the water absorbing rate, its water vapor permeability will become favorable for practical use.

The semiconductor device according to the present invention is characterized in that the adhesive layer contains a water permeable material of which the particles are not greater than 10 µm in the diameter.

The semiconductor device according to the present invention is characterized in that the particles of the water permeable material are not smaller than 0.01 µm in the diameter.

Since the adhesive layer contains a water permeable material of which the particles are not greater than 10 µm in the diameter, its resistance to moisture will certainly be improved. Also, the adhesive layer when having the water permeable material of which the particles are smaller than 0.01 µm in the diameter will be declined in the water vapor permeability. Accordingly, when its water permeable material particles are not smaller than 0.01 µm in the diameter, the adhesive layer will be increased in the water vapor permeability favorable for practical use.

The semiconductor device according to the present invention is characterized in that the adhesive layer contains photo-curing resin, thermosetting resin, and a water permeable material.

Since the adhesive layer includes photo-curing resin, thermosetting resin, and a water permeable material, it can be shaped and positioned at higher accuracy by a photolithographic technology. Also, two or more patterns of the adhesive layer can be provided at once. The adhesive layer when heated up can securely be bonded between the semiconductor substrate and the light-transmitting covering section as its bonding strength is improved.

A semiconductor module according to the present invention is a semiconductor module comprising: a wiring substrate having a conductor wiring provided thereon; and a semiconductor device according to the present invention mounted on the wiring substrate.

Since its semiconductor device is mounted on the wiring substrate having a conductor wiring, the semiconductor module can be minimized in the size and improved in the portability. In particular, the semiconductor module can be used as an optical device module which includes an imaging device as the semiconductor device and is small in the size and improved in the portability.

A manufacturing method of a semiconductor device according to the present invention is a manufacturing method of a semiconductor device, comprising the steps of bonding between a semiconductor substrate on which a plurality of semiconductor elements are mounted and covering section for covering each of the semiconductor elements by an adhesive layer; and separating the semiconductor substrate when the adhesive layer ranges from 10 g/(m²·24h) to 200 g/(m²·24h) in the water vapor permeability so as to complete each of the semiconductor elements provided with its covering section.

In the method according to the present invention, the semiconductor substrate on which a plurality of semiconductor elements is mounted is bonded to the covering section by the adhesive layer and then, the semiconductor substrate is separated with the adhesive layer ranging from 10 g/(m²·24h) to 200 g/(m²·24h) in the water vapor permeability so as to complete each of the semiconductor elements provided with its covering section. Since each of the semiconductor elements provided on the semiconductor substrate is protected with the covering section before separation of the semiconductor elements provided on the semiconductor substrate, the surface can be free from dust or unwanted injury at the succeeding step after the separation. Also, since the semiconductor substrate is separated with the adhesive layer ranging from 10 g/(m²·24h) to 200 g/(m²·24h) in the water vapor permeability, the space defined by the semiconductor substrate, the covering section, and the adhesive layer can be protected from being fouled with cutting water entering from the outside when the cutting water is used at the step of separation. Even if moisture enter the space, it can readily be discharged to the outside permitting no condensation.

The manufacturing method of a semiconductor device according to the present invention is characterized in that the adhesive layer contains photo-curing resin, thermosetting resin, and a water permeable material, and the step of bonding includes sub steps of forming the adhesive layer on the semiconductor substrate or the covering section; exposing the adhesive layer selectively to cure a predetermined area of the photo-curing resin included in the adhesive layer; removing an area of the adhesive layer of which the photo-curing resin remains not cured to form a pattern of the adhesive layer; and positioning the semiconductor substrate and the covering section to face each other through the adhesive layer of the pattern and curing the thermosetting resin included in the adhesive layer by heating thus to bond between the semiconductor substrate and the covering section.

Since the adhesive layer includes photo-curing resin, thermosetting resin, and a water permeable material, it can be arranged to a desired pattern on the semiconductor substrate or the covering section by a photolithographic technology using exposure and development processes due to the effect of the characteristics of the photo-curing resin included in the adhesive layer. After the semiconductor substrate and the covering section are positioned to face each other through the adhesive layer of the desired pattern, the adhesive layer is heated up to cure the thermosetting resin included in the adhesive layer for securely bonding between the semiconductor substrate and the covering section. As the photolithographic technology is used for forming a desired pattern of the adhesive layer on the semiconductor substrate or the covering section, the adhesive layer can be improved in both the accuracy and the pattern shape.

The manufacturing method of a semiconductor device according to the present invention is characterized in that the adhesive layer contains thermosetting resin and a water permeable material, and the step of bonding includes sub steps of printing the adhesive layer on the semiconductor substrate or the covering section with the use of a printing plate having a pattern corresponding to a predetermined area; and positioning the semiconductor substrate and the covering section to face each other through the adhesive layer printed down and curing the thermosetting resin included in the adhesive layer by heating thus to bond between the semiconductor substrate and the covering section.

Since the adhesive layer contains thermosetting resin and a water permeable material, it can be printed down (or transferred from the printing plate) on the semiconductor substrate or the covering section with the use of the printing plate having a pattern corresponding to a predetermined area. After the semiconductor substrate and the covering section are positioned to face each other through the adhesive layer printed down, the adhesive layer is heated up to cure the thermosetting resin included in the adhesive layer due to the effect of the characteristics of the thermosetting resin included in the adhesive layer for securely bonding between the semiconductor substrate and the covering section. As the adhesive layer is transferred from the printing plate onto the semiconductor substrate or the covering section, its formation will be carried out at lower cost thus improving the overall productivity

The manufacturing method of a semiconductor device according to the present invention is characterized in that the adhesive layer contains thermosetting resin and a water permeable material, and the step of bonding includes sub steps of dispensing the adhesive layer on the semiconductor substrate or the covering section so as to be a pattern corresponding to a predetermined area; and positioning the semiconductor substrate and the covering section to face each other through the dispensed adhesive layer and curing the thermosetting resin included in the adhesive layer by heating thus to bond between the semiconductor substrate and the covering section.

Since the adhesive layer contains thermosetting resin and a water permeable material, it can be dispensed on the semiconductor substrate or the covering section so as to be a pattern corresponding to a predetermined area. After the semiconductor substrate and the covering section are positioned to face each other through the adhesive layer, the adhesive layer is heated up to cure the thermosetting resin included in the adhesive layer due to the effect of the characteristics of the thermosetting resin for securely bonding between the semiconductor substrate and the covering section. As the dispenser is used for patterning the adhesive layer on the semiconductor substrate or the covering section, the patterning of the adhesive layer can be carried out at lower cost thus improving the overall productivity Also, if the pattern of the adhesive layer is injured and lost, it can readily be repaired using the dispenser.

A manufacturing method of a semiconductor device according to the present invention is a manufacturing method of a semiconductor device, comprising the steps of forming an adhesive layer including photo-curing resin, thermosetting resin, and a water permeable material on a semiconductor substrate on which a plurality of imaging elements with light receiving sections are mounted or on each of light-transmitting covering sections corresponding to the light receiving sections of the imaging elements; exposing the adhesive layer selectively to cure the photo-curing resin included in an area of the adhesive layer excluding the area of each of the light receiving sections; removing the area of the adhesive layer where the photo-curing resin remains not cured to form a pattern of the adhesive layer; positioning the semiconductor substrate and each of the covering sections to face each other through the adhesive layer of the pattern and curing the thermosetting resin included in the adhesive layer by heating thus to bond between the semiconductor substrate and each of the covering sections; and separating the semiconductor substrate when the adhesive layer ranges from 10 g/(m²·24h) to 200 g/(m²·24h) in the water vapor permeability so as to complete a semiconductor device having each of the imaging elements provided with its covering section.

In the method according to the present invention, the adhesive layer including photo-curing resin, thermosetting resin, and a water permeable material is provided on the semiconductor substrate on which a plurality of imaging elements with light receiving sections are mounted or on each of the light-transmitting covering sections for protecting the light receiving sections of the imaging elements. Then, the adhesive layer selectively is exposed to light to cure the photo-curing resin in a desired area of the adhesive layer excluding the area of the light receiving sections due to the effect of the characteristics of the photo-curing resin included in the adhesive layer before removing the area of the adhesive layer where the photo-curing resin remains not cured over each of the light receiving sections to have a desired pattern of the adhesive layer. After the semiconductor substrate and each of the covering sections are positioned to face each other through the adhesive layer of the desired pattern, the adhesive layer is heated up to cure the thermosetting resin included in the adhesive layer for securely bonding between the semiconductor substrate and each of the covering sections. Finally, the semiconductor substrate is separated when the adhesive layer ranges from 10 g/(m²·24h) to 200 g/(m²·24h) in the water vapor permeability so as to complete a semiconductor device having each of the imaging elements provided with its covering section. Before separation of the imaging elements provided on the semiconductor substrate into pieces, the imaging elements remain protected at the surface with the covering sections and can hardly be fouled with dusts or injured or scratched after the separation. Also, when the adhesive layer ranges from 10 g/(m²·24h) to 200 g/(m²·24h) in the water vapor permeability, the semiconductor substrate is separated. Accordingly, when the cutting water is used at the step of separation, it will be prevented from entering the space defined by the semiconductor substrate, the covering section, and the adhesive layer. Also, if the cutting water enter the space, it can readily be discharged to the outside thus permitting no condensation.

A manufacturing method of a semiconductor device according to the present invention is a manufacturing method of a semiconductor device, comprising the steps of forming an adhesive layer including photo-curing resin, thermosetting resin, and a water permeable material on a semiconductor substrate on which a plurality of imaging elements with light receiving sections are mounted or on a light-transmitting covering section for covering the light receiving sections of the imaging elements; exposing the adhesive layer selectively to cure the photo-curing resin including in an area of the adhesive layer excluding the area of each of the light receiving sections; removing the area of the adhesive layer where the photo-curing resin remains not cured to form a pattern of the adhesive layer; positioning the semiconductor substrate and the covering section to face each other through the adhesive layer of the pattern and curing the thermosetting resin included in the adhesive layer by heating thus to bond between the semiconductor substrate and the covering section; and separating the semiconductor substrate with the covering section mounted thereon when the adhesive layer ranges from 10 g/(m²·24h) to 200 g/(m²·24h) in the water vapor permeability so as to complete a semiconductor device having each of the imaging elements provided with its covering section.

In the method according to the present invention, the adhesive layer including photo-curing resin, thermosetting resin, and a water permeable material is provided on the semiconductor substrate on which a plurality of imaging elements with light receiving sections are mounted or on the light-transmitting covering section for covering the light receiving sections of the imaging elements. Then, the adhesive layer selectively is exposed to light to cure the photo-curing resin in a desired area of the adhesive layer excluding the area of each of the light receiving sections due to the effect of the characteristics of the photo-curing resin included in the adhesive layer before removing the area of the adhesive layer where the photo-curing resin remains not cured over each of the light receiving sections to have a desired pattern of the adhesive layer. After the semiconductor substrate and the light-transmitting covering section are positioned to face each other through the adhesive layer of the desired pattern, the adhesive layer is heated up to cure the thermosetting resin included in the adhesive layer for securely bonding between the semiconductor substrate and the covering section. Finally, the semiconductor substrate with the covering section mounted thereon is separated when the adhesive layer ranges from 10 g/(m²·24h) to 200 g/(m²·24h) in the water vapor permeability so as to complete a semiconductor device having each of the imaging elements provided with its covering section. Before separation of the imaging elements provided on the semiconductor substrate into pieces, the imaging elements remain protected at the surface with the light-transmitting covering section and can hardly be fouled with dusts or injured or scratched after the separation. Also, while the adhesive layer ranges from 10 g/(m²·24h) to 200 g/(m²·24h) in the water vapor permeability, the semiconductor substrate is separated. Accordingly, when the cutting water is used at the step of separation, it will be prevented from entering the space defined by the semiconductor substrate, the covering section, and the adhesive layer. Also, if the cutting water enter the space, it can readily be discharged to the outside thus permitting no condensation. Moreover, the adhesive layer bonded to the semiconductor substrate is positioned in relation with the corresponding imaging element, thus requiring no precise degree of the positional relationship between the adhesive layer and the covering section. In other words, so long as the semiconductor substrate and the covering section are positioned as a whole, the positioning of the imaging element in relation to the covering section will be unnecessary.

According to the present invention, the semiconductor substrate and the light-transmitting covering section for covering entirely the semiconductor substrate are bonded to each other by the adhesive layer of which the water vapor permeability ranges from 10 g/(m²·24h) to 200 g/(m²·24h). Accordingly, if moisture enter the space defined by the semiconductor substrate, the covering section, and the adhesive layer, it can readily be discharged to the outside thus permitting no condensation in the space. As a result, the space defined by the semiconductor substrate, the covering section, and the adhesive layer will be protected from being fouled with dusts from the outside and simultaneously improved in the resistance to moisture, thus permitting no condensation and contributing the improvement of the reliability and the environmental protection.

According to the present invention, the imaging element having a light receiving section is provided on the semiconductor substrate and the covering section is arranged to face the light receiving section. As the light receiving section is protected in the space defined by the semiconductor substrate, the covering section, and the adhesive layer, its surface can stay free from condensation.

According to the present invention, the adhesive layer is arranged in an area excluding the area of the light receiving section, thus preventing the light receiving section from being physically stressed by the adhesive layer and avoiding any declination in the light transmitting property between the light receiving section and the covering section.

According to the present invention, the two substrates are bonded to each other by the adhesive layer of which the water vapor permeability ranges from 10 g/(m²·24h) to 200 g/(m²·24h), thus allowing moisture to be readily discharged from the space defined by the two substrates and the adhesive layer when having entered under a high temperature, high moisture atmosphere. As a result, the space defined by the two substrates and the adhesive layer can stay free from condensation. Also, as the semiconductor element is provided on one surface of at least one of the two substrates with the adhesive layer positioned in an area excluding the area of the semiconductor element, it can certainly be protected from being fouled with moisture (humidity).

According to the present invention, the water absorbing rate of the adhesive layer is not higher than 20%, thus improving the resistance to moisture in the adhesive layer. Also, when the adhesive layer is lower than 3% in the water absorbing rate, its water vapor permeability will be declined. It is hence desired for increasing the water vapor permeability in practical use that the water absorbing rate of the adhesive layer is not smaller than 3% or preferably not smaller than 5%.

According to the present invention, the adhesive layer contains a water permeable material of which the particles are not greater than 10 µm in the diameter, thus improving the resistance to moisture in the adhesive layer. Also, when the particle diameter of the water permeable material is lower than 0.01 µm, the adhesive layer will be declined in the water vapor permeability It is hence desired for improving the water vapor permeability in the adhesive layer that the particles of the water permeable material are not smaller than 0.01 µm in the diameter.

According to the present invention, the adhesive layer includes photo-curing resin, thermosetting resin, and a water permeable material and can thus be shaped and positioned at higher accuracy by a known photolithographic technology. Also, two or more patterns of the adhesive layer can be provided at once. Moreover, when heated up, the adhesive layer can increase the bonding strength between the semiconductor substrate and the light-transmitting covering section.

According to the present invention, the covering section is bonded by the adhesive layer to the semiconductor substrate on which a plurality of semiconductor elements are mounted. Then, the semiconductor substrate is separated when the adhesive layer ranges from 10 g/(m²·24h) to 200 g/(m²·24h) in the water vapor permeability so as to complete each of the semiconductor elements provided with its covering section. As a result, each of the semiconductor elements provided on the semiconductor substrate remains protected at the surface with the covering section before separation of the semiconductor elements provided on the semiconductor substrate into pieces. After the step of separation, each of the semiconductor elements can be protected at the surface from being fouled with dust or injured. As the semiconductor substrate is separated when the adhesive layer ranges from 10 g/(m²·24h) to 200 g/(m²·24h) in the water vapor permeability, the cutting water used at the step of separation can be inhibited from entering the space defined by the semiconductor substrate, the covering section, and the adhesive layer. Moreover, even if water enters the space, it can readily be discharged to the outside thus permitting no condensation.

According to the present invention, the adhesive layer is patterned in a desired shape by a known photolithographic technology utilizing the effect of the characteristics of the photo-curing resin included in the adhesive layer and heated up for bonding between the semiconductor substrate and the covering section due to the effect of the characteristics of the thermosetting resin included in the adhesive layer. As a result, the desired pattern of the adhesive layer can be provided on the semiconductor substrate or the covering section accurately and finely by the photolithographic technology.

According to the present invention, the adhesive layer is printed (or transferred from a printing plate) on the semiconductor substrate or the covering section and heated up for bonding between the semiconductor substrate and the covering section due to the effect of the characteristics of the thermosetting resin included in the adhesive layer. As a result, the desired pattern of the adhesive layer can be printed down on the semiconductor substrate or the covering section using the printing plate at a lower cost thus contributing to the improvement of the productivity.

According to the present invention, the adhesive layer is patterned to a desired shape by dispensing on the semiconductor substrate or the covering section and heated up for bonding between the semiconductor substrate and the covering section due to the effect of the characteristics of the thermosetting resin included in the adhesive layer. As a result, the desired pattern of the adhesive layer can be provided on the semiconductor substrate or the covering section using a dispenser at a lower cost and contributing to the improvement of the productivity. Also, in case that the desired pattern of the adhesive layer is partially injured and lost, its loss can readily be repaired by the action of the dispenser.

According to the present invention, the action includes providing the adhesive layer including photo-curing resin, thermosetting resin, and a water permeable material on the semiconductor substrate on which a plurality of imaging elements with light receiving sections are mounted or on each of the light-transmitting covering sections corresponding to the light receiving sections of the imaging elements, exposing the adhesive layer selectively to cure the photo-curing resin in a desired area of the adhesive layer excluding the area of the light receiving sections due to the effect of the characteristics of the photo-curing resin included in the adhesive layer, removing the area of the adhesive layer where the photo-curing resin remains not cured over each of the light receiving sections to have a desired pattern of the adhesive layer, positioning the semiconductor substrate and each of the covering sections to face each other through the adhesive layer of the desired pattern and curing the thermosetting resin included in the adhesive layer by heating thus to bond between the semiconductor substrate and the covering section, and separating the semiconductor substrate when the adhesive layer ranges from 10 g/(m²·24h) to 200 g/(m²·24h) in the water vapor permeability so as to complete a semiconductor device having each of the imaging elements provided with its covering section. As a result, each of the imaging elements provided on the semiconductor substrate remain protected at the surface with the covering section before separation of the imaging elements provided on the semiconductor substrate into pieces. After the step of separation, each of the imaging elements can be protected at the surface from being fouled with dust or injured. As the semiconductor substrate is separated when the adhesive layer ranges from 10 g/(m²·24h) to 200 g/(m²·24h) in the water vapor permeability, the cutting water used at the step of separation can be inhibited from entering the space defined by the semiconductor substrate, the covering section, and the adhesive layer. Moreover, even if water enters the space, it can readily be discharged to the outside thus permitting no condensation.

According to the present invention, the action includes providing the adhesive layer including photo-curing resin, thermosetting resin, and a water permeable material on the semiconductor substrate on which a plurality of imaging elements with light receiving sections are mounted or on the light-transmitting covering section for covering the light receiving sections of the imaging elements, exposing the adhesive layer selectively to cure the photo-curing resin in a desired area of the adhesive layer excluding the area of each of the light receiving sections due to the effect of the characteristics of the photo-curing resin included in the adhesive layer, removing the area of the adhesive layer where the photo-curing resin remains not cured over each of the light receiving sections to have a desired pattern of the adhesive layer, positioning the semiconductor substrate and the covering section to face each other through the adhesive layer of the desired pattern and curing the thermosetting resin included in the adhesive layer by heating thus to bond between the semiconductor substrate and the covering section, and separating the semiconductor substrate with the covering section mounted thereon when the adhesive layer ranges from 10 g/(m²·24h) to 200 g/(m²·24h) in the water vapor permeability so as to complete a semiconductor device having each of the imaging elements provided with its covering section. As a result, the imaging elements provided on the semiconductor substrate remain protected at the surfaces with the covering section before separation of the imaging elements provided on the semiconductor substrate into pieces. After the step of separation, the imaging elements can be protected at the surfaces from being fouled with dust or injured. As the semiconductor substrate with the covering section mounted thereon is separated when the adhesive layers range from 10 g/(m²·24h) to 200 g/(m²·24h) in the water vapor permeability, the cutting water used at the step of separation can be inhibited from entering the space defined by the semiconductor substrate, the covering section, and the adhesive layer. Moreover, even if moisture enters the space, it can readily be discharged to the outside thus permitting no condensation. Also, the adhesive layer when provided on the semiconductor substrate can be positioned in relation with each of the imaging elements thus eliminating the positioning at high accuracy between the adhesive layer and the light-transmitting covering section in one extra step. In other words, so long as the semiconductor substrate and the covering section are positioned as a whole, the positioning of each of the imaging elements in relation to the covering section will be unnecessary.

The above and further objects and features of the invention will more fully be apparent from the following detailed description with accompanying drawings.

### BRIEF DESCRIPTION OF THE SEVERAL VIEWS OF THE DRAWINGS

FIG. 1 is a plan view schematically showing an arrangement of a conventional imaging device;
FIG. 2 is a structure cross sectional view taken along the line XI-XI of FIG. 1;
FIGS. 3A and 3B are explanatory views showing a schematic arrangement of an imaging device as the semiconductor device according to Embodiment 1 of the present invention;
FIGS. 4A and 4B are explanatory views illustrating steps of manufacturing the imaging device as the semiconductor device of Embodiment 1;
FIGS. 5A and 5B are explanatory views illustrating steps of manufacturing the imaging device as the semiconductor device of Embodiment 1**;**
FIGS. 6A to 6C are explanatory views illustrating steps of manufacturing the imaging device as the semiconductor device of Embodiment 1;
FIG. 7 is a table diagram showing the result of a reliability test for the imaging device as the semiconductor device of Embodiment 1;
FIG. 8 is a table diagram showing the result of the reliability test for the imaging device as the semiconductor device of Embodiment 1;
FIGS. 9A and 9B are explanatory views illustrating steps of manufacturing an imaging device as the semiconductor device according to Embodiment 2 of the present invention;
FIGS. 10A to 10C are explanatory views illustrating steps of manufacturing the imaging device as the semiconductor device of Embodiment 2; and
FIG. 11 is a structure cross sectional view schematically showing an arrangement of a semiconductor module according to Embodiment 3 of the present invention.

### DETAILED DESCRIPTION OF THE INVENTION

The following description will explain in detail the present invention, based on the drawings illustrating some embodiments thereof. As is embodied in the form of an imaging device where a semiconductor substrate having an imaging element provided thereon is bonded with a light-transmitting lid section (covering section) according to the present invention by an adhesive layer, as a semiconductor device, the present invention is not limited to the embodiment.

### (Embodiment 1)

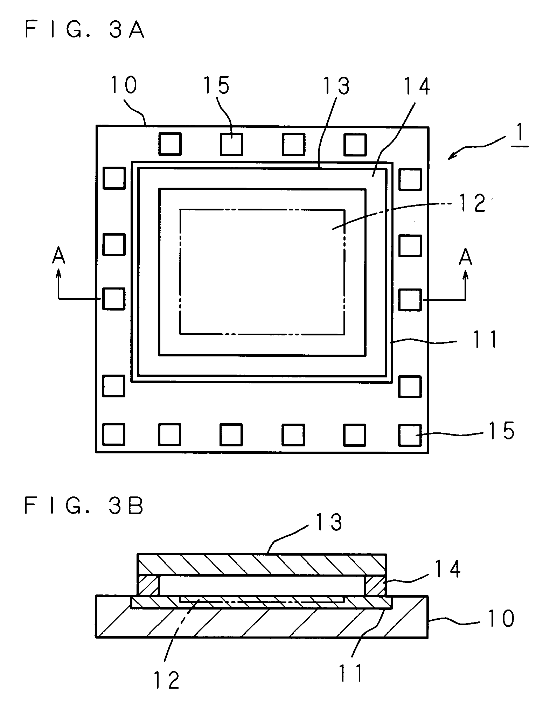

FIGS. 3A and 3B illustrate a schematic arrangement of the imaging device as a semiconductor device according to Embodiment 1 of the present invention. More specifically, FIG. 3A is a plan view (from above) of the imaging device and FIG. 3B is a structure cross sectional view taken along the line A-A of FIG. 3A.

The imaging device 1 as a semiconductor device according to Embodiment 1 of the present invention comprises a semiconductor substrate 10 on which an imaging element 11 is disposed of a rectangular shape when shown from above, a lid section 13 provided opposite to a light receiving section 12 at one surface of the imaging element 11, and an adhesive layer 14 provided on the one surface, except the light receiving section 12, of the imaging device 11 for bonding between the semiconductor substrate 10 (the imaging element 11) and the lid section 13.

The imaging device 1 is designed for taking in the incident light passed through the lid section 13 and receiving (detecting) the light with a light receiving element at the light receiving section 12 of the imaging element 11. The lid section 13 is made of a light-transmitting material such as glass, and protecting (the surface of) the light receiving section 12 from being fouled with moistures or dusts (dirt or scraps) from the outside by covering the light receiving section 12 at least. As the planar dimension (size) of the lid section 13 is smaller than that of the semiconductor substrate 10 (of the imaging element 11), the imaging device 1 can be minimized in the overall size. The imaging element 11 may be a CCD or a CMOS imager.

There is a space developed between the lid section 13 and the semiconductor substrate 10 (the light receiving section 12) when the lid section 13 is bonded by the adhesive layer 14 to the imaging element 11 excluding the light receiving section 12. As the space allows the incident light passed through the lid section 13 to fall directly on the light receiving section 12, any light energy loss will hardly be occurred along the light path. Although not shown, an array of micro lenses are provided on the surface of the light receiving section 12 for focusing the incident light on the light receiving element of each pixel. The space can also protect the micro lens array from being damaged. A plurality of bonding pads 15 are provided as terminals between the adhesive layer 14 (the lid section 13) and the outer edge (chip edge) of the semiconductor substrate 10 for connecting the imaging element 11 with an outside circuit (not shown). The bonding pads 15 are also connected to the imaging element 11 by a wiring layer (not shown) provided on the semiconductor substrate 10.

The adhesive layer 14 is provided along the outer edge of the lid section 13 for sealing the space between the light receiving section 12 and the lid section 13 disposed opposite to each other. The sealed space between the light receiving section 12 and the lid section 13 protects (the surface of) the light receiving section 12 from being fouled or damaged with any entering impurities and turned to a defective.

The adhesive layer 14 contains photo-curing resin, thermosetting resin, and water permeable material and has a water vapor permeability of 10 to 200 g/(m²·24h) and a water absorbing rate of 3 to 20%. The water permeable material may be provided in the form of particles ranging from 0.01 to 10 µm in the diameter. As is provided with the adhesive layer 14 using the specific material, the space between the light receiving section 12 and the lid section 13 or (the surface of) the light receiving section 12 can remain free from moisture entering. Accordingly, with its light receiving section 12 protected from condensation, the imaging device 1 can be improved in the resistance to moisture. The water vapor permeability, the water absorbing rate, and the particle diameter of the water permeable material of the adhesive layer 14 will be explained later.

In brief, the adhesive layer 14 composed of the specific material described above is provided between the semiconductor substrate 10 and the lid section 13, thus protecting the light receiving section 12 on the semiconductor substrate 10 from being fouled or damaged with any impurities or moisture and contributing to the higher productivity and reliability of the imaging device 1.

It is necessary to protect the surface of the light receiving section 12 from being exposed to infrared rays as well as protection against impurities or dusts when the imaging device 1 is mounted in an optical apparatus such as a camera or a video camera. For the purpose, the lid section 13 may have an infrared ray insulating film provided on the surface thereof and act as an optical filter.

A manufacturing method of the described-above imaging device 1 will now be described.

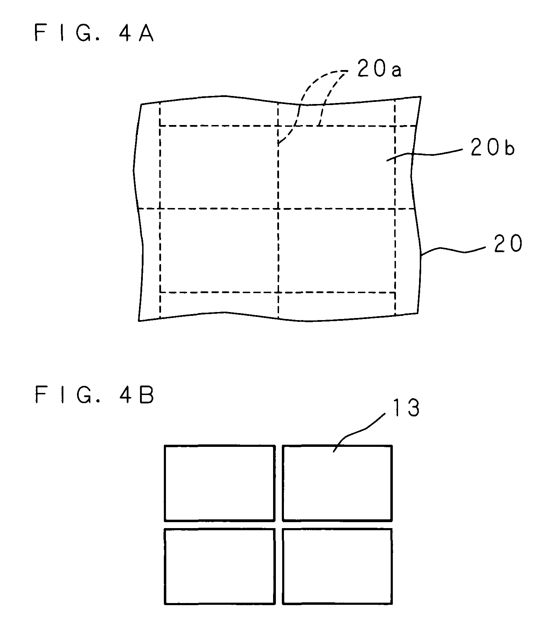

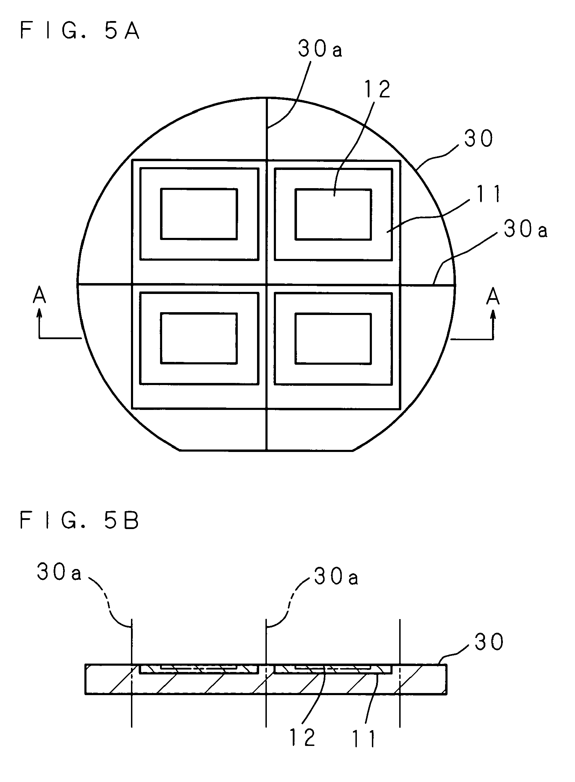

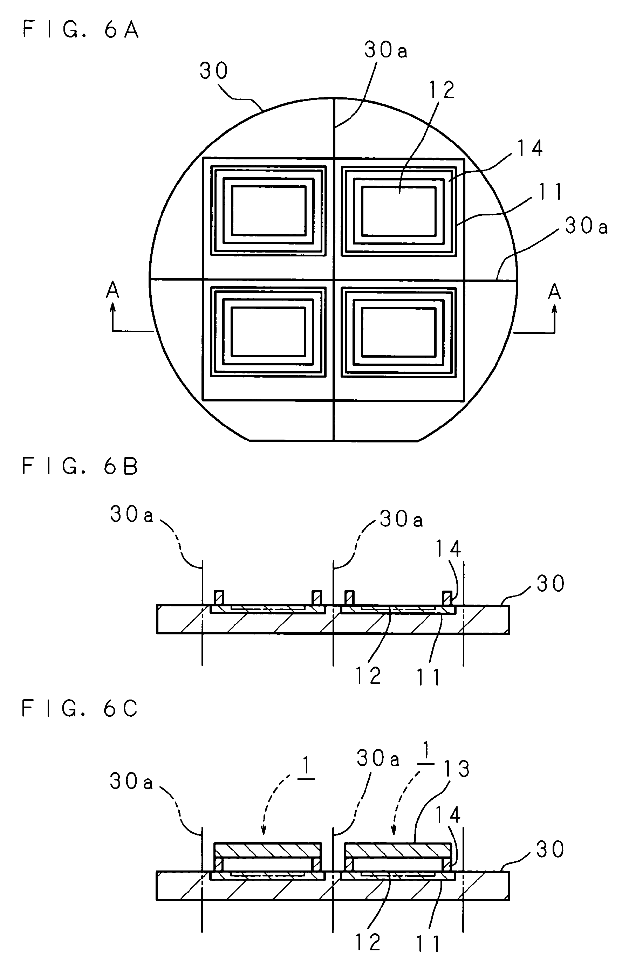

FIGS. 4A, 4B, 5A, 5B, 6A, 6B, and 6C illustrate the manufacturing method of an imaging device as the semiconductor device according to Embodiment 1 of the present invention. More specifically, FIGS. 4A and 4B are explanatory views showing steps of fabricating the lid sections. FIGS. 5A and 5B are explanatory views showing the imaging devices provided on a semiconductor wafer. FIGS. 6A to 6C are explanatory views showing steps of bonding the lid sections fabricated by the steps shown in FIGS. 4A and 4B to one surface of imaging elements (the surface provided with the light receiving sections) on the semiconductor wafer.

FIG. 4A illustrates a large size of light-transmitting plate material 20 such as a glass plate. The light-transmitting plate material 20 is large enough to include a number of lid section corresponding regions 20b defined by separation lines 20a. The lid section corresponding regions 20b are adjustably sized so that, when having been separated at the succeeding step, they are identical in the planar size to the lid sections 13.

FIG. 4B illustrates the light-transmitting plate material 20 separated by dicing along the separation lines 20a into the lid section corresponding regions 20b (pieces) which thus turn to the light-transmitting lid sections 13. More particularly, the light-transmitting plate material 20 is bonded to a dicing tape secured on a dicing ring and then separated with a dicing saw traveling in the direction of dicing (along the separation lines 20a) thus to form the individual lid sections 13.

FIG. 5A illustrates the imaging elements 11 provided on a semiconductor wafer 30. Each of the imaging elements 11 having the light receiving section 12 is defined by the separation lines 30a. FIG. 5B is a structure cross sectional view taken long the line A-A of FIG. 5A.

FIG. 6A illustrates the adhesive layer 14 patterned, except the light receiving section 12, on the surface (including the light receiving section 12) of each of the imaging elements 11 on the semiconductor wafer 30. FIG. 6B is a structure cross sectional view taken along the line A-A of FIG. 6A. The specific material of the adhesive layer 14 is prepared by mixing photo-curing resin (e.g., ultraviolet setting resin or namely acrylic resin) and thermosetting resin (e.g., epoxy resin) with a water permeable material (e.g., zeolite of porous water permeable particles) and coated uniformly over the surface of the semiconductor wafer 30 having the imaging elements 11. Using a known photolithographic technology such as exposure and development steps, the coating is patterned to develop the adhesive layer 14 on each of the imaging elements 11. More specifically, the adhesive layers 14 on the respective imaging elements 11 provided on the semiconductor wafer 30 are fabricated at once thereby increasing the productivity of the imaging devices.

Since ultraviolet setting resin is used as the photo-curing resin in this embodiment, it is masked with a photomask having a predetermined pattern and then exposed to ultraviolet rays at the exposure step. The regions of the photo-curing resin exposed to the ultraviolet rays are thus cured to develop a bonding strength and turned to the adhesive layers 14 on the semiconductor wafer 30. Then, the adhesive layers 14 are subjected to the development step using a proper liquid developer where the not exposed regions of the photo-curing resin (remaining not cured) are removed. As a result, the adhesive layers 14 are fabricated in a desired patterned form.

In this embodiment, the adhesive layer 14 is patterned to have a line width of 100 µm, a thickness of 50 µm, and a planer pattern of 3 × 3 mm. The specific material in this embodiment containing the photo-curing resin and thermosetting resin as a main component is highly favorable for high-precision patterning of the adhesive layer 14 which may range from 30 µm to 500 µm in the line width, from 5 µm to 200 µm in the thickness, and from 0.5 mm to 10 mm in each surface of the planar pattern.

Alternatively, the adhesive layers 14 may be provided when having been shaped to a desired pattern at the preceding step. In this case, the material of the adhesive layer has no use for the photo-curing resin. For example, the adhesive layers 14 composed of the specific material including the thermosetting resin and the water permeable material are transferred (by printing, e.g., screen printing) onto the semiconductor wafer 30 through a printing plate having a desired pattern form, thereby fabricating the adhesive layers 14 having the desired patterned form on the semiconductor wafer 30 directly. The printing technology will contribute to the cost down of the step for fabricating the adhesive layers 14, thus improving the productivity.

Moreover, the adhesive layers 14 may be fabricated directly on the semiconductor wafer 30 by a dispenser for dispensing the specific material including the setting resin and the water permeable material as being moved over the semiconductor wafer 30 (dispenser method). This dispenser method also conducts the step of fabricating the adhesive layers 14 at lower cost, thus improving the productivity. This dispenser method may also be used for repairing the pattern of the adhesive layers 14 when any fault is found in the pattern of the adhesive layers 14.

The step of fabricating the adhesive layers 14 can be carried out by any applicable method suited for the specific material of the adhesive layers 14, the light-transmitting plate material 20, or the imaging devices 1. In this embodiment, the adhesive layers 14 contain the specific material including photo-curing resin so that the patterning of the adhesive layers 14 is implemented by the photolithographic technology.

FIG. 6C illustrates the prefabricated light-transmitting lid sections 13 (see FIG. 4B) bonded by the adhesive layers 14 to the corresponding imaging elements 11 on the semiconductor wafer 30. More particularly, the light-transmitting lid sections 13 are positioned over the adhesive layers 14, and the thermosetting resin included in the adhesive layers 14 is cured to develop a bonding strength by heating up (by exposure to infrared ray). As a result, the light-transmitting lid sections 13 can be bonded by the bonding strength of the adhesive layers 14 to the semiconductor wafer 30. The property of the adhesive layers 14 after the thermosetting resin is cured will be explained later including the water vapor permeability.

The space between the light receiving section 12 and the lid section 13 is sealed by the adhesive layer 14, thus protecting (the surface of) the light receiving section 12 from being fouled or injured with moisture, impurities, or dusts from the outside.

The semiconductor wafer 30 to which the lid sections 13 are bonded down is then separated into the imaging device 1 by dicing along the separation lines 30a. The dicing may generally be carried out using cutting water. As each of the adhesive layers 14 has water permeability described later, it prevents the cutting water from entering the space defined by the adhesive layer 14 between the lid section 13 and the semiconductor wafer 30, thus permitting no disturbance of the cutting water in the sealed space including the surface of the light receiving section 12. Even if moisture enters the space, it can be removed through the adhesive layer 14 to the outside but not produce condensation in the space.

Using the foregoing steps, the imaging device 1 according to the present invention can be produced. It should be noted that there is a region at the outside of the light receiving section 12 where an area of bonding pads (not shown) are provided for connecting the imaging device 11 with an outside circuit (not shown). Also, the light receiving section 12 remains protected at any of the succeeding steps; it can not be injured when the imaging device 1 is transferred by, e.g., vacuum suction.

In this embodiment, when the adhesive layers 14 have been patterned on the semiconductor wafer 30, the lid sections 13 are positioned to face the surface where the adhesive layers 14 are provided on the semiconductor wafer 30 and heated up for curing its contained thermosetting resin and thus bonded with the semiconductor wafer 30. Alternatively, the lid sections 13 may first be bonded to the adhesive layers 14 and then bonded by heating up and curing the thermosetting resin included in the adhesive layers 14 with the semiconductor wafer 30 which has been placed to face the surface of the lid sections 13 where the adhesive layers 14 are bonded.

The test for evaluating some samples of the specific material of the adhesive layer 14 will now be explained where the water permeable material (namely porous particles of zeolite) is varied in the particle diameter as well as its water absorbing rate and water vapor permeability with respect to the imaging device 1 of this embodiment. In fact, samples of the described-later semiconductor module (a camera module) of Embodiment 3 of the present invention were produced and examined for the reliability.

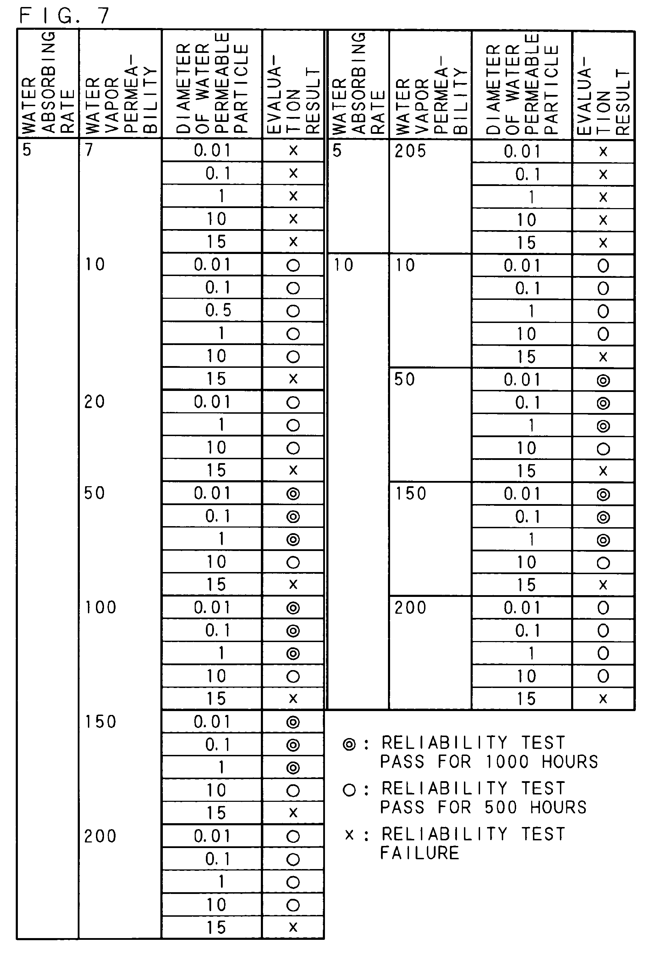

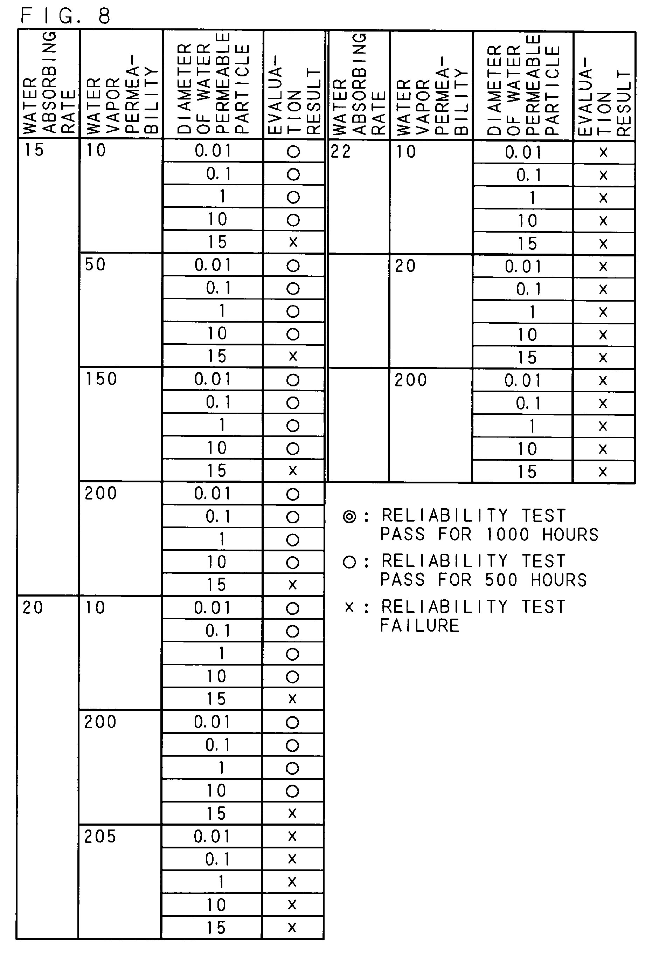

FIGS. 7 and 8 are tables showing the result of the test for examining the reliability of the imaging device as the semiconductor device of Embodiment 1.

Using the water vapor permeability test (a cup method) for anti-moisture packaging materials conforming to JIS-Z0208, each sample having a cured resin film of a circular shape, 6 mm in the diameter and 100 µm in the thickness, provided by a spacer of 500 µm thick was installed in a moisture permeable cup, held under a high moisture and high temperature atmosphere (90% RH at 40°C), and measured at equal intervals of 24 hours for finding a change in the weight. It was defined that the change in the weight was a true value when remained uniform. The water vapor permeability (g/(m²·24h)) was then calculated by dividing the true value of the weight change by the area (of the circle of 6 mm in the diameter) of the cured resin film.

For examining the water absorbing rate, each sample having a cured resin film, 6 mm in the diameter and 100 µm in the thickness, was prepared and its mass was measured prior to the test. The sample was then subjected to the test of absorbing water (moisture) under an atmosphere of 90% RH (relative humidity percent) at 40°C for 168 hours and its mass was measured again. The water absorbing rate was determined from a percentage by weight (wt%).

The water permeable material of zeolite was prepared to contain 10 to 75 wt % so as to obtain the values of the water vapor permeability and the water absorbing rate as shown in FIGS. 7 and 8. The samples were classified by the particle diameter of the water permeable material into four groups; not greater than 10 µm, not greater than 1 µm, not greater than 0.1 µm, and not greater than 0.01 µm. The test was not explained with samples having smaller sizes of the particle diameter. It was found that the particle diameter was as preferable as not smaller than 0.01 µm. It would be understood that the water permeability of the water permeable material depends significantly on its porous property.

The reliability test involves holding the imaging device under a high temperature, high moisture atmosphere for a predetermined length of time before returning it to the normal atmosphere and examining whether the sealed space defined by the semiconductor substrate 10, the lid section 13, and the adhesive layer 14 is fouled with dirt or condensation. The reliability test may be implemented by either examining images produced with the imaging element 11 or observing the imaging device from outside. The reliability test according to this embodiment was carried out with each sample held under a high temperature, high moisture atmosphere of 90% RH at 60°C for 500 hours and 1000 hours before returning back to the normal atmosphere. In FIGS. 7 and 8, the symbol Θ indicates that no dirt or condensation was found after 1000 hours, the symbol ○ indicates that some dirt or condensation was found after a period ranging from 500 hours to 1000 hours, and the symbol × indicates that some dirt or condensation was found before 500 hours have elapsed.

### (1. Water Vapor Permeability)

It was found that all the samples of which the water vapor permeability was 7 g/(m²·24h) produced some condensation in the space before reaching to 500 hours from the start of the test. The condensation may result from the fact that moisture once trapped is hardly discharged from the space to the outside readily when the water vapor permeability is lower than 10 g/(m²·24h). Some of the samples of which the water vapor permeability exceeded 10 g/(m²·24h) produced no condensation in the space after a duration of 500 hours from the start of the test.

Also, all the samples of which the water vapor permeability ranged from 10 g/(m²·24h) to 20 g/(m²·24h) produced some condensation in the space before reaching to 1000 hours from the start of the test. The condensation may result from the fact that moisture once trapped can be discharged from the space but also gradually accumulated and then the accumulated moisture amount exceeds a critical mass to produce condensation when the water vapor permeability is lower than 20 g/(m²·24h). Some of the samples of which the water vapor permeability exceeded 50 g/(m²·24h) produced no condensation in the space after a duration of 1000 hours from the start of the test.

Moreover, all the samples of which the water vapor permeability was 205 g/(m²·24h) produced some impurities in the space before reaching to 500 hours from the start of the test. The generation of impurities may result from the fact that the water permeable particles (zeolite) become detachable due to the particle diameters and contents thereof and some are separated from the adhesive layer 14 to be impurities when the water vapor permeability exceeds 200 g/(m²·24h). Some of the samples of which the water vapor permeability was not higher than 200 g/(m²·24h) produced no impurities in the space after a duration of 500 hours from the start of the test.

In addition, all the samples where the water vapor permeability was 200 g/(m²·24h) produced some impurities in the space before reaching to 1000 hours from the start of the test. The generation of impurities may result from the fact that the water permeable particles (zeolite) become detachable due to the particle diameters and contents thereof and some are separated from the adhesive layer 14 to be impurities when the water vapor permeability exceeds 150 g/(m²·24h). Some of the samples of which the water vapor permeability was not higher than 150 g/(m²·24h) produced no impurities in the space after a duration of 1000 hours from the start of the test.

As concluded, the samples of which the water vapor permeability ranges from 10 g/(m²·24h) to 200 g/(m²·24h) have passed the reliable test under a high temperature, high moisture atmosphere for a period of 500 hours. The samples of which the water vapor permeability ranges from 50 g/(m²·24h) to 150 g/(m²·24h) have passed the reliable test under a high temperature, high moisture atmosphere for a period of 1000 hours.

### (2. Water Absorbing Rate)

It was found that all the samples of which the water absorbing rate is 22% produced some impurities in the space before reaching to 500 hours from the start of the test. The generation of impurities may result from the fact that the water permeable particles (zeolite) become detachable due to the particle diameters and contents thereof and some are separated from the adhesive layer 14 to be impurities when the water absorbing rate exceeds 20%. Some of the samples of which the water absorbing rate was not higher than 20% produced no impurities and condensation in the space after a duration of 500 hours from the start of the test.

Also, all the samples of which the water absorbing rate was 15% or 20% produced some impurities in the space before reaching to 1000 hours from the start of the test. The generation of impurities may result from the fact that the water permeable particles (zeolite) become detachable due to the particle diameters and contents thereof and some are separated from the adhesive layer 14 to be impurities when the water absorbing rate exceeds 10%. Some of the samples of which the water absorbing rate was not higher than 10% produced no impurities and condensation in the space after a duration of 1000 hours from the start of the test.

As concluded, the samples of which the water absorbing rate is not higher than 20% have passed the reliable test under a high temperature, high moisture atmosphere for a period of 500 hours while the samples of which the water absorbing rate is not higher than 10% have passed the reliable test under a high temperature, high moisture atmosphere for a period of 1000 hours. When the water absorbing rate is lower than 3%, the water vapor permeability of the adhesive layer 14 will be declined. It is hence preferable for improving the water vapor permeability of the adhesive layer 14 that the water absorbing rate is not lower than 3% or more preferably not lower than 5%.

### (3. Diameter of Water Permeable Particle (zeolite)

It was found that all the samples of which the water permeable particles (zeolite) are 15 µm in the diameter produced some impurities in the space before reaching to 500 hours from the start of the test. The generation of impurities may result from the fact that the water permeable particles become detachable and some are separated from the adhesive layer 14 to be impurities when their diameter exceeds 10 µm. Some of the samples of which the water permeable particles (zeolite) are 10 µm in the diameter produced no impurities and condensation in the space after a duration of 500 hours from the start of the test.

Also, all the samples of which the water permeable particles (zeolite) are 10 µm in the diameter produced some impurities in the space before reaching to 1000 hours from the start of the test. The generation of impurities may result from the fact that the water permeable particles become detachable and some are separated from the adhesive layer 14 to be impurities when their diameter exceeds 1 µm. Some of the samples of which the water permeable particles (zeolite) are 1 µm in the diameter produced no impurities and condensation in the space after a duration of 1000 hours from the start of the test.

As concluded, the samples of which the water permeable particles are not greater than 10 µm in the diameter have passed the reliable test under a high temperature, high moisture atmosphere for a period of 500 hours while the samples of which the water permeable particles are not greater than 1 µm have passed the reliable test under a high temperature, high moisture atmosphere for a period of 1000 hours. When the diameter of the water permeable particles is lower than 0.01 µm, the water vapor permeability of the adhesive layer 14 will be declined. It is hence preferable that the diameter of the water permeable particles is not lower than 0.01 µm.

### (Embodiment 2)

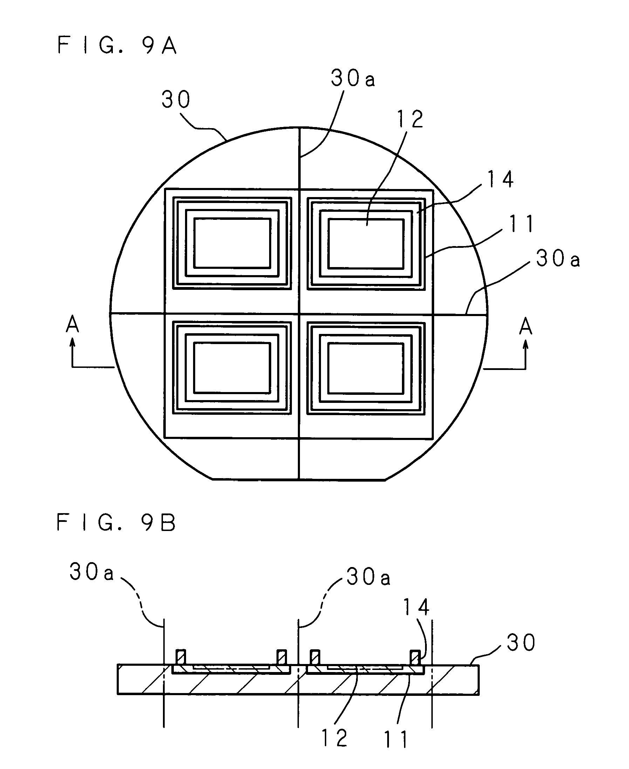

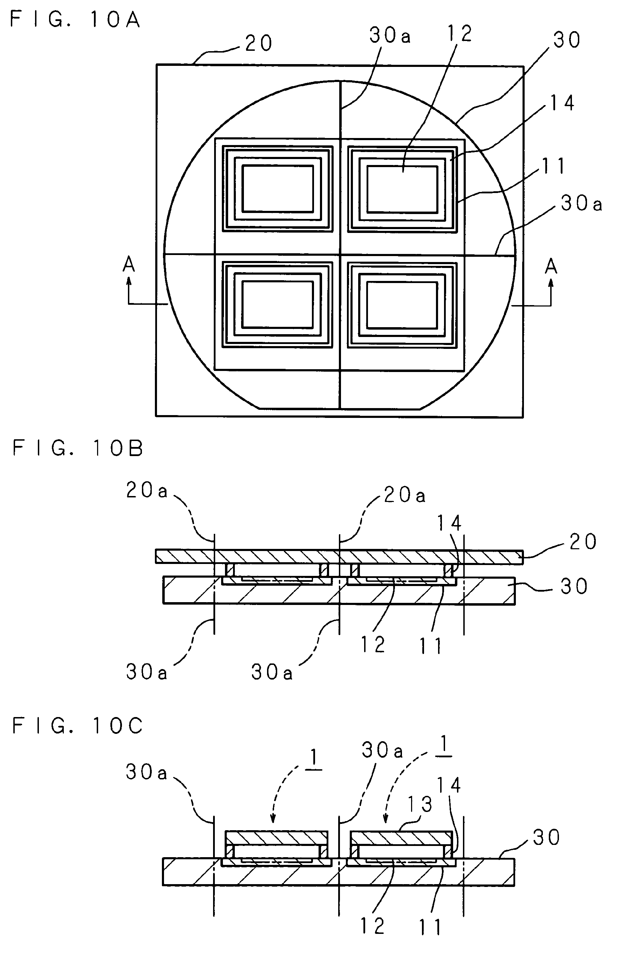

FIGS. 9A, 9B, 10A, 10B, and 10C illustrate a manufacturing method of the imaging device as a semiconductor device according to Embodiment 2 of the present invention. More particularly, FIGS. 9A and 9B are explanatory views showing the adhesive layer provided on one surface (including the light receiving section) of each of imaging elements on the semiconductor wafer. FIGS. 10A to 10C are explanatory views showing steps of bonding a light-transmitting plate material on the semiconductor wafer shown in FIGS. 9A and 9B and separating the light-transmitting plate material to develop the lid sections of the imaging devices.

FIG. 9A illustrates the adhesive layer 14 patterned, in a peripheral area except the light receiving section 12, on the surface (including the light receiving sections 12) of each of the imaging elements 11 on the semiconductor wafer 30. FIG. 9B is a structure cross sectional view taken along the line A-A of FIG. 9A. The illustrations are identical to those of Embodiment 1 shown in FIGS. 6A and 6B. The formation of the adhesive layer 14 and the condition at its step are also identical to those of Embodiment 1.

FIG. 10A illustrates the light-transmitting plate material 20 bonded to the semiconductor wafer 30 shown in FIGS. 9A and 9B on which each of the imaging elements 11 is provided with its adhesive layer 14. More particularly, the light-transmitting plate material 20 is positioned over the adhesive layers 14 on the semiconductor wafer 30 and bonded to the adhesive layers 14 by heating up (including exposure to infrared ray). Since the adhesive layers 14 are provided previously at position on the corresponding imaging elements 11, the installation of the light-transmitting plate material 20 needs not to be highly accurate. Simply, the light-transmitting plate material 20 can be positioned so as to cover the semiconductor wafer 30 but not coincide with the respective imaging devices 11.

FIG. 10B is a structure cross sectional view taken along the line A-A of FIG. 10A. As the semiconductor wafer 30 is covered entirely with the light-transmitting plate material 20, the light receiving sections 12 remain tightly protected when being transferred or stored. Since the space between the light receiving section 12 and the lid section 13 is sealed up by the adhesive layer 14, the light receiving section 12 can be protected (at the surface) from being fouled with moisture or dusts and injured or damaged by impurities.

FIG. 10C is a structure cross sectional view of the light-transmitting plate material 20 on the semiconductor wafer 30 diced along the separation lines 20a to form the lid sections 13. More specifically, the light-transmitting plate material 20 is bonded to the semiconductor wafer 30 and separated into the lid sections 13. Then, the semiconductor wafer 30 on which the lid sections 13 are bonded is separated by dicing along the separation lines 30a into the respective imaging devices 1. While the cutting water is applied during the action of dicing similar to that of Embodiment 1, the adhesive layer 14 having the described-above water vapor permeability can prevent the cutting water from entering the space defined by the semiconductor wafer 30, the lid section 13, and the adhesive layer 14. Accordingly, the space including the surface of the light receiving section 12 is protected from being fouled with the cutting water. Even if the space is fouled with moisture, it allows the moisture to be discharged easily and will not suffer from condensation.

The described method involves providing a pattern of the adhesive layers 14 on the corresponding imaging elements 11 (see FIGS. 9A and 9B), bonding the light-transmitting plate material 20 to the semiconductor wafer 30, and dicing the light-transmitting plate material 20 into the lid sections 13 (FIGS. 10A to 10C). Alternatively, a step of providing a pattern of the adhesive layers 14 on the light-transmitting plate material 20 may be followed by bonding the light-transmitting plate material 20 to the semiconductor wafer 30 and dicing the light-transmitting plate material 20 into the lid sections 13. It is however required in the latter case to carry out the positional matching between the adhesive layers 14 on the light-transmitting plate material 20 and the light receiving sections 12 of the imaging elements 11.

According to Embodiments 1 and 2, the light receiving sections 12 remain protected from being fouled with any cutting scraps generated during the dicing of the light-transmitting plate material 20 and the semiconductor wafer 30 (by the effect of a particular structure where each of the light receiving sections 12 is sealed with the adhesive layer 14). In addition, since the lid sections 13 are positioned opposite to and bonded to the corresponding light receiving sections 12 prior to the separation into the imaging elements 11, they can protect the surface of the light receiving sections 12 from being fouled with dusts and injured by impurities at any succeeding step after the separation into the imaging elements 11. Accordingly, the generation of defectives will be minimized after the mounting process of the imaging elements 11 or particularly after the separation process. Also, since the lid sections 13 are arranged smaller in the planar area than the imaging elements 11, the imaging devices 1 can be scaled down to a chip size. As there is no need for accurately controlling the cleanness of the working area (production environment) after the step of bonding the lid sections 13, the overall production is simplified and its cost can significantly be declined.

### (Embodiment 3)

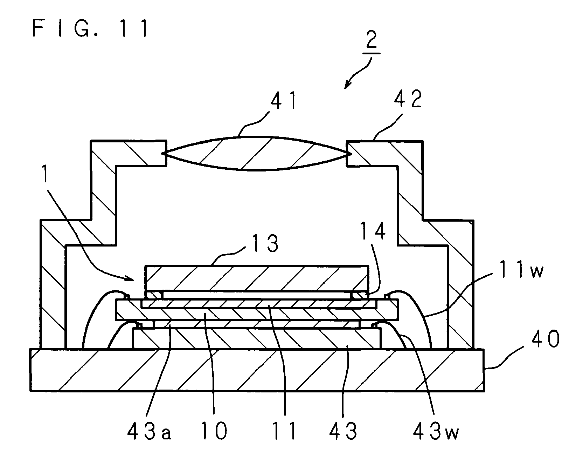

FIG. 11 is a structure cross sectional view of a schematic arrangement of a semiconductor module according to Embodiment 3 of the present invention. The semiconductor module 2 may be a camera module where a lens 41 for focusing the incident light and a lend holder 42 for holding the lens 41 are mounted on a wiring substrate 40 such as a printed circuit board or a ceramic board. Also, a digital signal processor 43 (referred to as a DSP hereinafter) is provided on the wiring substrate 40. The DSP 43 functions as a controller (image processing apparatus) for controlling the action of the imaging device 1 (imaging element 11) and converting output signals of the imaging device 1 (imaging element 11) into relevant signals which can commonly be used in an optical apparatus. The DSP 43 is electrically connected at its connecting terminals by bonding wires 43w to corresponding a wiring (not shown) on the wiring substrate 40.

The imaging device 1 acting as the semiconductor device of the present invention is mounted on the DSP 43 of a semiconductor chip form through a spacer 43a. The imaging element 11 of the imaging device 1 is electrically connected at its connecting terminals (the bonding pads 15 shown in FIGS. 3A and 3B) by bonding wires 11w to corresponding a wiring (not shown) on the wiring substrate 40. The semiconductor substrate 10 of the imaging device 1 on which the imaging element 11 is mounted is covered with the light-transmitting lid section 13 which is positioned to face the lens 41 and secured by the adhesive layer 14. In brief, the imaging element 11 is installed in the lens holder 42. As the cover 13 is arranged smaller in the planar area than the imaging element 11, the lens holder 42 can be minimized to a limit size. As a result, the semiconductor module 2 can be minimized to a chip size suited for installation in an applicable optical apparatus.

Although the imaging device 1 is mounted by the DSP 43 to the wiring substrate 40 as shown in FIG. 11, it may be mounted directly to the wiring substrate 40. The DSP 43 may be mounted to one surface of the wiring substrate 40 where the imaging device 1 is mounted or its opposite surface where the imaging device 1 is not mounted.

The present invention is not limited to the foregoing embodiments of the imaging device and the semiconductor module but may be applied to any semiconductor device or module, such as EPROM, which has a light receiving section provided with a light-transmitting lid section made of, e.g., glass. Also, the light-transmitting lid section is not limited to glass but may be made of any applicable material.

The lid section may further be made of a semiconductor material such as silicon or in the form of semiconductor chip in addition to glass, on other types of semiconductor device or module to which the present invention is applicable. Simultaneously, the adhesive layer may contain an electrically conductive adhesive material for allowing the electrical connection.

## Claims

1. A semiconductor device comprising a semiconductor substrate (10); a covering section (13) for covering the semiconductor substrate (10); and an adhesive layer (14) for bonding between the semiconductor substrate (10) and the covering section (13), **characterized in that**
the water vapor permeability of the adhesive layer (14) ranges from 10 g/(m²·24h) to 200 g/(m²·24h).

2. The semiconductor device according to claim 1, wherein
the semiconductor substrate (10) has an imaging element (11) with a light receiving section (12) provided thereon, and the covering section (13) is positioned to face the light receiving section (12).

3. The semiconductor device according to claim 2, wherein
the adhesive layer (14) is arranged in an area excluding the area of the light receiving section (12).

4. A semiconductor device comprising: two substrates provided with a semiconductor element mounted on one surface of at least one of the two substrates so as to face the other substrate; and an adhesive layer (14) for bonding between the two substrates, arranged on the one surface excluding the area where the semiconductor element is mounted, **characterized in that**
a water vapor permeability of the adhesive layer (14) ranges from 10 g/(m²·24h) to 200 g/(m²·24h).

5. The semiconductor device according to any one of claims 1 to 4, wherein
the adhesive layer (14) has a water absorbing rate of not higher than 20%.

6. The semiconductor device according to claim 5, wherein
the adhesive layer (14) has a water absorbing rate of not smaller than 3%.

7. The semiconductor device according to any one of claims 1 to 4, wherein
the adhesive layer (14) contains a water permeable material of which the particles are not greater than 10 µm in the diameter.

8. The semiconductor device according to claim 7, wherein
the particles of the water permeable material are not smaller than 0.01 µm in the diameter.

9. The semiconductor device according to any one of claims 1 to 4, wherein
the adhesive layer (14) contains photo-curing resin, thermosetting resin, and a water permeable material.

10. A semiconductor module **characterized by** comprising:
a wiring substrate (40) having a conductor wiring provided thereon; and
a semiconductor device (1) of any one of claims 1 to 4 mounted on the wiring substrate (40).

11. A manufacturing method of a semiconductor device, **characterized by** comprising the steps of
bonding between a semiconductor substrate (30) on which a plurality of semiconductor elements are mounted and covering section (13) for covering each of the semiconductor elements by an adhesive layer (14); and
separating the semiconductor substrate (30) when the adhesive layer (14) ranges from 10 g/(m²·24h) to 200 g/(m²·24h) in the water vapor permeability so as to complete each of the semiconductor elements provided with its covering section (13).

12. The manufacturing method of a semiconductor device according to claim 11, wherein
the adhesive layer (14) contains photo-curing resin, thermosetting resin, and a water permeable material, and
the step of bonding includes sub steps of
forming the adhesive layer (14) on the semiconductor substrate (30) or the covering section (13);
exposing the adhesive layer (14) selectively to cure a predetermined area of the photo-curing resin included in the adhesive layer (14);
removing an area of the adhesive layer (14) of which the photo-curing resin remains not cured to form a pattern of the adhesive layer (14); and
positioning the semiconductor substrate (30) and the covering section (13) to face each other through the adhesive layer (14) of the pattern and curing the thermosetting resin included in the adhesive layer (14) by heating thus to bond between the semiconductor substrate (30) and the covering section (13).

13. The manufacturing method of a semiconductor device according to claim 11, wherein
the adhesive layer (14) contains thermosetting resin and a water permeable material, and
the step of bonding includes sub steps of
printing the adhesive layer (14) on the semiconductor substrate (30) or the covering section (13) with the use of a printing plate having a pattern corresponding to a predetermined area; and
positioning the semiconductor substrate (30) and the covering section (13) to face each other through the adhesive layer (14) printed down and curing the thermosetting resin included in the adhesive layer (14) by heating thus to bond between the semiconductor substrate (30) and the covering section (13).

14. The manufacturing method of a semiconductor device according to claim 11, wherein
the adhesive layer (14) contains thermosetting resin and a water permeable material, and
the step of bonding includes sub steps of
dispensing the adhesive layer (14) on the semiconductor substrate (30) or the covering section (13) so as to be a pattern corresponding to a predetermined area; and
positioning the semiconductor substrate (30) and the covering section (13) to face each other through the dispensed adhesive layer (14) and curing the thermosetting resin included in the adhesive layer (14) by heating thus to bond between the semiconductor substrate (30) and the covering section (13).

15. A manufacturing method of a semiconductor device, **characterized by** comprising the steps of
forming an adhesive layer (14) including photo-curing resin, thermosetting resin, and a water permeable material on a semiconductor substrate (30) on which a plurality of imaging elements (11) with light receiving sections (12) are mounted or on each of light-transmitting covering sections (13) corresponding to the light receiving sections (12) of the imaging elements (11);
exposing the adhesive layer (14) selectively to cure the photo-curing resin included in an area of the adhesive layer (14) excluding the area of each of the light receiving sections (12);
removing the area of the adhesive layer (14) where the photo-curing resin remains not cured to form a pattern of the adhesive layer (14);
positioning the semiconductor substrate (30) and each of the covering sections (13) to face each other through the adhesive layer (14) of the pattern and curing the thermosetting resin included in the adhesive layer (14) by heating thus to bond between the semiconductor substrate (30) and each of the covering sections (13); and
separating the semiconductor substrate (30) when the adhesive layer (14) ranges from 10 g/(m²·24h) to 200 g/(m²·24h) in the water vapor permeability so as to complete a semiconductor device (1) having each of the imaging elements (11) provided with its covering section (13).

16. A manufacturing method of a semiconductor device, **characterized by** comprising the steps of
forming an adhesive layer (14) including photo-curing resin, thermosetting resin, and a water permeable material on a semiconductor substrate (30) on which a plurality of imaging elements (11) with light receiving sections (12) are mounted or on a light-transmitting covering section (20) for covering the light receiving sections (12) of the imaging elements (11);
exposing the adhesive layer (14) selectively to cure the photo-curing resin including in an area of the adhesive layer (14) excluding the area of each of the light receiving sections (12);
removing the area of the adhesive layer (14) where the photo-curing resin remains not cured to form a pattern of the adhesive layer (14);
positioning the semiconductor substrate (30) and the covering section (20) to face each other through the adhesive layer (14) of the pattern and curing the thermosetting resin included in the adhesive layer (14) by heating thus to bond between the semiconductor substrate (30) and the covering section (20); and
separating the semiconductor substrate (30) with the covering section (20) mounted thereon when the adhesive layer (14) ranges from 10 g/(m²·24h) to 200 g/(m²·24h) in the water vapor permeability so as to complete a semiconductor device (1) having each of the imaging elements (11) provided with its covering section (13).
